# FASCICULE DE BREVET EUROPEEN

(11) **EP 0 724 753 B1**
(45) Date de publication et mention de la délivrance du brevet: **01.04.1998**
(21) Numéro de dépôt: 94931618.6
(22) Date de dépôt: 21.10.1994
(51) Int. Cl.: G06K 9/20, G06K 7/10, H01L 21/00

(54) **PROCEDES ET DISPOSITIFS D'IDENTIFICATION DE CARACTERES INSCRITS SUR DES SUBSTRATS**
VERFAHREN UND EINRICHTUNGEN ZUR ERMITTLUNG AUF EINEM SUBSTRAT AUFGEZEICHNETER ZEICHEN
METHODS AND DEVICES FOR IDENTIFYING CHARACTERS WRITTEN ON SUBSTRATES

(30) Priorité: 21.10.1993 FR 9312770
(43) Date de publication de la demande: 07.08.1996
(73) Titulaire: RECIF S.A., 31840 Aussonne (FR)
(72) Inventeur: DEGROOT, Roy, Antioch, CA 94509 (US); LEONOV, Mark, Santa Clara, CA 95051 (US); AULAGNON, Marcel, F-31840 Aussonne (FR); POLI, Bernard, F-31480 Cox (FR)
(74) Mandataire: Morelle, Guy Georges Alain
(86) Numéro de dépôt international: FR9401228
(87) Numéro de publication internationale: WO9511491

(56) Documents cités:
- EP-A- 0 320 671
- FR-A- 2 594 982
- US-A- 3 899 687

## Description

La présente invention se rapporte aux domaines de la fabrication des composants électroniques, notamment la fabrication des circuits intégrés à partir de substrats ou plaquettes en matériaux semiconducteurs, et plus particulièrement aux procédés et aux dispositifs d'identification ou de reconnaissance de ces substrats, à tous moments des processus de fabrication automatisés, à partir de caractères distinctifs, notamment sous forme alphanumériques ou de codes barres, inscrits sur chaque substrat.

L'Art Antérieur nous enseigne un procédé largement répandu d'identification de caractères gravés sur des substrats en forme de plaquettes, plus précisément sur une des faces de chaque plaquette, qui consiste à déplacer au moyen d'un bras manipulateur chaque plaquette à l'horizontale, ces dernières étant rangées de façon alignée les unes derrière les autres dans des rainures respectives d'un panier disposé verticalement, pour sortir la plaquette du panier, puis l'orienter angulairement grâce à un repérage sur sa périmétrie sous forme d'encoche ou de méplat, de façon à présenter la portion de surface portant les caractères à identifier dans l'alignement de l'axe optique d'une caméra et d'un système d'éclairage, et perpendiculairement à ces derniers.

Ce procédé présente de nombreux inconvénients, notamment un temps relativement long de cycle d'identification des caractères, de l'ordre de 4 à 6 minutes pour traiter 25 plaquettes, dû en particulier à la manipulation des plaquettes, un encombrement important en raison du bras manipulateur, un accroissement de la contamination particulaire des plaquettes dû à la présence d'éléments mécaniques au dessus de ces plaquettes, comme le système d'éclairage et la caméra, enfin un investissement et un coût d'exploitation relativement élevés en particulier par la présence d'un bras manipulateur.

Il existe également une autre solution qui consiste à orienter angulairement toutes les plaquettes d'un panier sur un équipement, puis à identifier les caractères des plaquettes sur un autre équipement sans sortir celles-ci de leur panier, au moyen de miroirs placés sous les plaquettes. Toutefois, il est nécessaire à cet effet de relever les deux plaquettes positionnées avant celle à identifier, et ces multiples manipulations peuvent être source de contamination particulaire des plaquettes.

On rencontre enfin une autre solution qui permet une orientation angulaire et une identification des plaquettes disposées dans un même panier, sur un même équipement, mais les systèmes de caméra et d'éclairage sont disposés au dessus des plaquettes provoquant une forte turbulence de l'air ambiant et augmentant ainsi le risque de contamination particulaire des plaquettes.

La présente invention a pour but de remédier à ces différents inconvénients et d'apporter d'autres avantages. Plus précisément, elle consiste en un procédé d'identification de caractères, gravés sur un substrat, caractérisé en ce qu'il comporte au moins les étapes suivantes :
* éclairer de manière directe lesdits caractères au moyen d'au moins une première source lumineuse située dans un premier plan passant par une surface plane minimale qui inscrit la totalité desdits caractères et définissant un premier angle avec une perpendiculaire à ladite surface plane, ladite première source lumineuse étant située sur une droite passant par ladite surface plane et formant un deuxième angle avec un deuxième plan perpendiculaire à ladite surface plane et perpendiculaire audit premier plan,
* observer lesdits caractères avec des moyens d'observation électroniques comprenant un axe optique au moins parallèle audit deuxième plan et déterminant un troisième angle avec ladite perpendiculaire à ladite surface plane, ledit axe optique formant avec ledit plan un angle inférieur ou égal à 25°,
* identifier lesdits caractères au moins avec un logiciel de reconnaissance à réseaux de neurones, et
* déplacer au moins la source lumineuse et lesdits moyens d'observation électroniques en translation parallèlement à un axe d'alignement de ladite pluralité des substrats, pour les placer en position d'identification d'un deuxième substrat.

Selon des caractéristiques avantageuses, lesdits premier et deuxième angles sont compris entre 35° et 65° et de préférence égaux à 45°, ledit troisième angle est compris entre 40° et 60° et de préférence égal à 48°.

Le procédé selon l'invention permet d'obtenir au moyen d'un éclairage de biais des caractères, une image de ces derniers indépendante des lignes de gravures exclusivement verticales et horizontales qui apparaissent sur les plaquettes au cours des étapes de fabrication qu'elles suivent, et qui couvrent parfois la portion de surface sur laquelle sont inscrits les caractères d'identification de chaque plaquette. Ces lignes de gravures verticales et horizontales pouvaient induire avec les dispositifs de l'Art Antérieur une perturbation de l'image observée et de ce fait entraîner un taux d'erreurs accru dans l'identification des caractères, lui-même provoquant un taux de rebut plus élevé des plaquettes. L'éclairage de biais permet également d'obtenir un contraste plus élevé des caractères observés par rapport à la surface sur laquelle sont gravés ces derniers. En effet, les rayons lumineux incidents réfléchis sur ladite surface ne sont pas dans l'axe optique d'observation comme cela est notamment le cas lorsque les rayons lumineux et l'axe optique sont perpendiculaires à la surface d'inscription des caractères.

De plus, l'éclairage de biais, ainsi que la position de biais de l'axe optique de la caméra permettent une observation des caractères de chaque plaquette sans déplacement de celle-ci par rapport aux autres, lorsqu'elles sont placées dans un panier. L'identification des caractères ainsi éclairés et observés est rendue possible notamment grâce à un logiciel de reconnaissance à réseau de neurones.

Selon une caractéristique avantageuse, le procédé selon l'invention est caractérisé en ce que l'on éclaire lesdits caractères au moyen d'au moins une deuxième source lumineuse symétrique à ladite première source lumineuse par rapport audit deuxième plan.

Cette caractéristique permet un éclairage symétrique par rapport à l'axe optique de la caméra d'ou un traitement de l'image plus simple pour l'identification des caractères.

Selon une caractéristique avantageuse, le procédé selon l'invention est caractérisé en ce que l'on éclaire lesdits caractères au moyen d'une pluralité de sources lumineuses située dans une pluralité de plans passant par ladite surface plane, et définissant une pluralité d'angles respectifs avec une perpendiculaire à ladite surface plane.

La pluralité de sources lumineuses permet une plus grande modulation de l'éclairage, par variation de l'intensité lumineuse de chaque source en fonction des besoins, notamment en fonction de l'aspect de la surface inscrivant les caractères qui peut notamment présenter des dépôts d'oxyde sombre ou réflecteur de façon aléatoire.

L'invention a aussi pour objet un dispositif d'identification de caractères, gravés sur des substrats, comprenant des moyens de positionnement desdits substrats, des moyens d'éclairage desdits caractères, des moyens d'observation desdits caractères, et des moyens d'identification desdits caractères, caractérisé en ce que lesdits moyens d'éclairage comprennent au moins une première source lumineuse située dans un premier plan passant par une surface plane minimale qui inscrit la totalité desdits caractères d'un substrat et définissant un premier angle avec une perpendiculaire à ladite surface plane, ladite première source lumineuse étant située sur une droite passant par ladite surface plane et formant un deuxième angle avec un deuxième plan perpendiculaire à ladite surface plane et perpendiculaire audit premier plan, et en ce que lesdits moyens d'observation comprennent une caméra électronique transmettant au moins une image auxdits moyens d'identification et comprenant un axe optique au moins parallèle audit deuxième plan, déterminant un troisième angle avec ladite perpendiculaire à ladite surface plane, et formant avec ledit premier plan un angle inférieur ou égal à 25°, et en ce que ledit dispositif comprend des moyens de déplacement en translation desdits moyens d'éclairage et desdits moyens d'observation parallèlement à une axe d'alignement desdits substrats.

D'autres caractéristiques et avantages apparaîtront à la lecture de la description d'un exemple qui suit de mode de réalisation d'un dispositif et d'un procédé d'identification de caractères inscrits sur des substrats selon l'invention, accompagnés des dessins annexés, exemples donnés à titre d'illustration sans qu'aucune interprétation restrictive de l'invention ne puisse en être tirée.

La Figure 1 représente schématiquement en vue de profil un premier exemple de mode de réalisation de la géométrie des moyens d'éclairage et d'observation d'un dispositif selon l'invention.

La Figure 2 représente schématiquement en vue de face suivant F2 l'exemple illustré sur la Figure 1.

La Figure 3 représente schématiquement en vue de dessus suivant F1 l'exemple illustré sur la Figure 1.

La Figure 4 représente schématiquement en vue de profil un deuxième exemple de mode de réalisation de la géométrie des moyens d'éclairage d'un dispositif selon l'invention.

La Figure 5 est une représentation schématique, fonctionnelle, et partielle en vue de profil d'un exemple de mode de réalisation d'un dispositif selon l'invention comprenant des moyens d'éclairage et des moyens d'observation selon les Figures 1, 2, et 3.

La Figure 6 représente en vue de profil un exemple de mode de réalisation d'un dispositif selon l'invention suivant la Figure 5.

La Figure 7 représente en vue de face l'exemple de mode de réalisation d'un dispositif selon l'invention suivant la Figure 6.

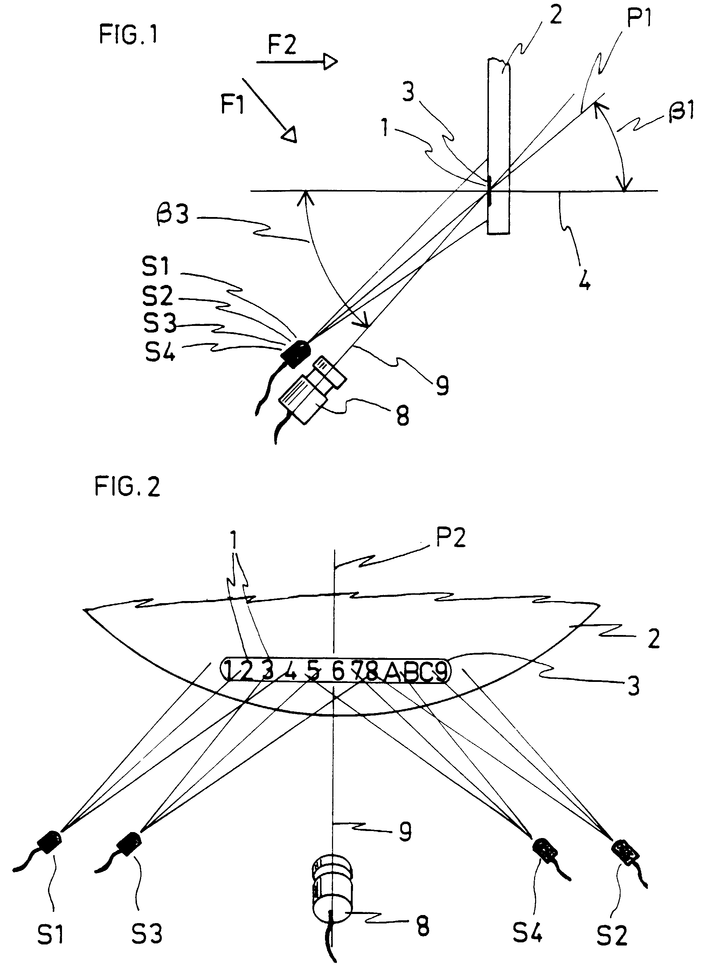

La géométrie des moyens d'éclairage et d'observation du dispositif selon l'invention illustré partiellement sur la Figure 1 est montrée en vue de profil parallèle à un premier plan P1, et dans une position d'identification des caractères 1 d'un substrat en forme de plaquette 2. Les moyens d'éclairage comprennent avantageusement une première S1, deuxième S2, troisième S3, et quatrième S4 sources lumineuses, assurées notamment au moyen de quatre diodes électroluminescentes (LED). Les quatre sources lumineuses S1, S2, S3, et S4 sont placées sensiblement dans le plan P1 passant par une surface 3 plane minimale qui inscrit la totalité des caractères 1 du substrat. Le plan P1 définit un premier angle β1, avantageusement de l'ordre de 45°, avec une perpendiculaire 4 à la surface 3, et contient avantageusement un des plus grands axes de la surface 3, comme le montre la Figure 1.

La plaquette 2 est d'un type couramment utilisé dans l'industrie électronique, en forme de disque de faible épaisseur sur une face duquel sont gravés les caractères d'identité de la plaquette dans une zone proche de sa circonférence, comme illustré sur la Figure 2. Les exemples de plaquette 2 et de caractères 1 illustrés sur les Figures ne sont pas à l'échelle, sont représentatifs de ceux couramment rencontrés mais nullement restrictifs, tous autres modes de caractères, par exemple des codes barres, inscrits sur tous autres types de plaquettes, pouvant être identifiés avec le dispositif selon la présente invention.

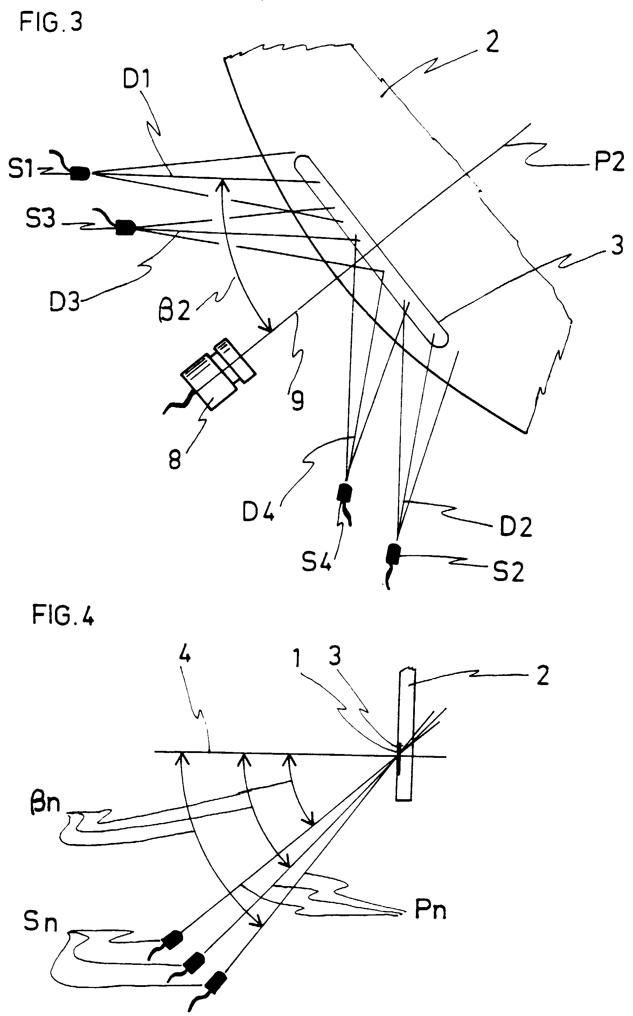

Dans le plan P1, chacune des première S1, deuxième S2, troisième S3, et quatrième S4 sources lumineuses est respectivement située sensiblement sur première D1, deuxième D2, troisième D3, et quatrième D4 droites passant par la surface 3 et formant notamment un deuxième angle β2, avantageusement de l'ordre de 45°, avec un deuxième plan P2 perpendiculaire à la surface 3 et perpendiculaire au premier plan P1, comme le montre la Figure 3 qui est une vue suivant F1 de la Figure 1 (vue perpendiculaire au premier plan P1).

Les première S1, et troisième S3 sources lumineuses sont avantageusement respectivement symétriques des deuxième S2 et quatrième S4 sources lumineuses par rapport au deuxième plan P2, comme le montrent les Figures 2 et 3.

Les quatre sources lumineuses S1, S2, S3, et S4 dirigent leurs faisceaux lumineux, notamment coniques, en direction des caractères 1, et sont avantageusement situées à une distance sensiblement égale de la surface 3. La distance séparant les sources lumineuses du deuxième plan P2 est avantageusement telle que les faisceaux lumineux qu'elles émettent sont au moins sécant au niveau de la surface 3, par exemple tel que cela est représenté sur les Figures 2 et 3.

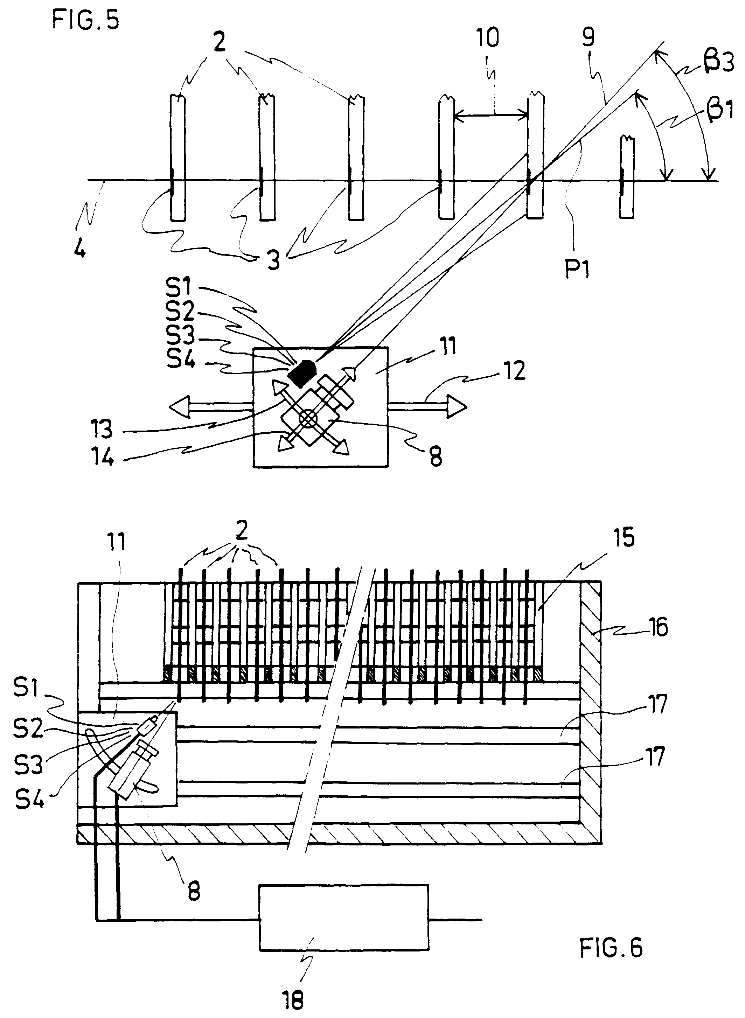

Les Figures 1, 2, et 3 illustrent également la géométrie des moyens d'observation comprenant avantageusement une caméra électronique 8 munie d'un axe optique 9. La caméra 8 observe les caractères 1 éclairés par les quatre sources lumineuses S1, S2, S3, et S4 selon son axe optique 9 avantageusement confondu avec le deuxième plan P2 et formant un troisième angle β3 avec la perpendiculaire 4 à la surface 3, comme le montrent les Figures 1, 2, et 3. Le troisième angle β3 est avantageusement réglable, notamment entre les valeurs de 40° et 60°, comme cela sera décrit plus amplement avec l'aide des Figures 5, 6, et 7.

Un deuxième exemple de mode de réalisation de la géométrie des moyens d'éclairage du dispositif selon l'invention est illustré schématiquement sur la Figure 4. Les moyens d'éclairage comprennent une pluralité de sources lumineuses Sn située dans une pluralité de plans Pn passant par ladite surface 3 et définissant une pluralité d'angles respectifs βn, avantageusement de l'ordre de 45°, avec une perpendiculaire 4 à la surface 3. Chacun des plans de la pluralité de plans Pn est avantageusement disposé de manière similaire à celle décrite sur les Figures 1, 2, et 3, ainsi que chacune des sources lumineuses de la pluralité de sources lumineuses Sn dans chacun des plans.

La Figure 5 illustre un exemple de la cinématique des moyens d'éclairage et des moyens d'observation possédant avantageusement la géométrie décrite suivant les Figures 1, 2, et 3 d'un exemple de mode de réalisation d'un dispositif selon l'invention.

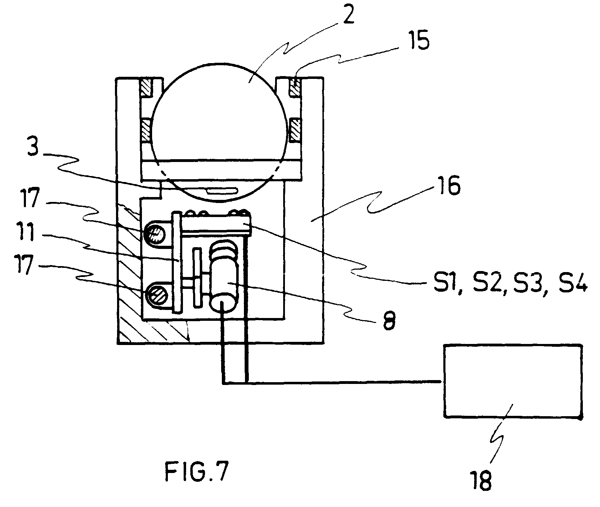

Les plaquettes 2 sont immobiles et disposées de façon à ce que les caractères d'identité qu'elles portent soient alignés, les surfaces 3 étant sensiblement parallèles, comme cela sera décrit plus loin avec les Figures 6 et 7. Les quatre sources lumineuses S1, S2, S3, et S4 sont fixées sur un support 11 avantageusement mobile, par rapport aux plaquettes, en translation suivant une direction 12 parallèle à une perpendiculaire 4 aux surfaces planes 3. La caméra 8 est fixée sur le support 11 avantageusement de manière à pouvoir se déplacer en translation par rapport à ce dernier dans une direction 14 parallèle à son axe optique 9 et également en rotation par rapport au support 11 sensiblement autour de l'axe de plus grande longueur de la surface 3, suivant une direction 13.

Le déplacement en translation du support 11 suivant la direction 12 permet l'éclairage et l'observation des caractères de chaque plaquette, le déplacement de la caméra 8 en translation suivant la direction 14 permet une optimisation de l'observation, et le déplacement de la caméra 8 en rotation suivant la direction 13 permet d'ajuster l'observation notamment en fonction de l'intervalle 10 séparant chaque plaquette, par un réglage approprié du troisième angle β3.

On remarquera que dans le cas ou les plaquettes sont alignées suivant un axe horizontal comme représenté sur la Figure 5, les moyens d'éclairage et d'observation sont avantageusement conçus pour agir en étant placés sous les plaquettes, ces dernières restant immobiles pendant toute la durée du procédé d'identification, selon l'invention, de toutes les plaquettes. Cette immobilité des plaquettes et le positionnement au dessous de celles-ci des moyens d'éclairage et des moyens d'observation permettent notamment de minimiser la contamination particulaire des plaquettes.

Les Figures 6 et 7 représentent respectivement en vue de profil et en vue de face un exemple de mode de réalisation du dispositif selon l'invention suivant la Figure 5.

Le dispositif comprend des moyens de positionnement des plaquettes 2 incluant, une structure 16 apte à maintenir avantageusement en position horizontale un panier 15 comportant les plaquettes 2 disposées chacune verticalement l'une derrière l'autre dans une rainure selon un intervalle régulier variable selon le format des plaquettes, et un mécanisme (non représenté) pour orienter angulairement toutes les plaquettes 2 autour de leur axe d'alignement avantageusement de façon à ce que les caractères d'identité de chaque plaquette soient alignés dans la position la plus basse par rapport au panier 15, tel que représenté sur la Figure 7. Il est à noter que le mécanisme d'orientation angulaire des plaquettes est un mécanisme connu couramment rencontré permettant d'aligner les encoches ou méplats (non représentés) que portent les plaquettes sur leurs circonférences. Ce mécanisme est avantageusement placé à l'intérieur de la structure 16 et au dessous du panier 15, et peut être avantageusement contrôlable à partir d'une unité centrale 18, ce qui autorise la possibilité d'un pilotage automatique dudit mécanisme.

Le dispositif comprend également des moyens d'éclairage et des moyens d'observation avantageusement tel que définis par les Figures 1, 2, 3, et 5. Le support 11 est par exemple guidé en translation le long de deux barres guides 17 parallèles à un axe d'alignement des plaquettes. Les guidages en translation et en rotation de la caméra 8 par rapport au support 11 sont assurés de toutes façons connues, par exemple par des systèmes de glissières (non représentés), et les déplacements de la caméra 8 par rapport au support 11 sont notamment réalisés manuellement. La position de la caméra 8 par rapport au support 11 est réglée avant un processus d'identification. Les déplacements du support 11 sont avantageusement motorisés (non représenté) de toutes façons connues, et contrôlables par l'intermédiaire de l'unité centrale 18 de façon à assurer la possibilité d'un pilotage automatique des déplacements des moyens d'éclairage et d'observation. De même, les fonctionnements de la caméra 8 et des sources lumineuses S1, S2, S3, et S4 sont avantageusement contrôlables par l'intermédiaire de l'unité centrale 18, de façon à assurer la possibilité d'un pilotage automatique complet des moyens d'éclairage et d'observation et /ou d'une surveillance de l'identification des caractères par l'intermédiaire d'un moniteur (non représenté).

Le dispositif comprend également des moyens d'identification des caractères en fonction de l'image observée et transmise avantageusement par la caméra 8 à ces derniers, incluant notamment un logiciel de traitement d'images, et un logiciel de reconnaissance des caractères à réseaux de neurones.

Le logiciel de traitement d'images permet avantageusement de dégrossir l'image transmise, et le logiciel de reconnaissance à réseaux de neurones permet avantageusement à un opérateur de visualiser et d'identifier les caractères, par exemple par l'intermédiaire d'un moniteur (non représenté). Le logiciel de reconnaissance à réseaux de neurones permet également de convertir une image transmise en informations aptes à être exploitées par un traitement informatique sur réseau. Dans ce dernier cas d'utilisation notamment, l'unité centrale est avantageusement munie d'un logiciel de gestion de cycles d'identification des plaquettes adapté selon les besoins à une étape de processus ou à un processus de fabrication déterminé. Le dispositif selon l'invention offre ainsi la possibilité d'un pilotage entièrement automatique.

Le logiciel de reconnaissance à réseaux de neurones apporte notamment un avantage de rapidité de reconnaissance des caractères donc un gain de productivité, et un taux d'erreurs d'identification de caractères faible donc un faible taux de rebuts de fabrication.

Il faut remarquer que les moyens de positionnement des plaquettes et les moyens d'éclairage et d'observation des caractères du dispositif selon l'invention s'insèrent dans un volume relativement compact notamment du fait de l'immobilité des plaquettes durant les procédés d'identification et du fait de l'intégration des moyens d'éclairage, des moyens d'observation, et du mécanisme d'orientation des plaquettes au dessous du panier. Une utilisation intensive de matériaux plastiques permet d'obtenir un poids inférieur à 15 kg ce qui autorise des déplacements et transports aisés. Enfin, une intégration informatique permet une utilisation du dispositif selon l'invention en communication avec un réseau.

## Revendications

1. Procédé d'identification de caractères, gravés sur une pluralité de substrats disposés verticalement et immobiles, ***caractérisé en ce qu'***il comporte au moins les étapes suivantes :
* éclairer de manière directe les caractères (1) d'un premier substrat (2) de ladite pluralité de substrats au moyen d'au moins une première source lumineuse (S1), ladite première source lumineuse (S1) étant située au dessous de ladite pluralité de substrats, ladite première source lumineuse (S1) étant située dans un premier plan (P1) passant par une surface (3) plane minimale qui inscrit la totalité desdits caractères dudit premier substrat et définissant un premier angle (β1) avec une perpendiculaire (4) à ladite surface plane, ladite première source lumineuse étant située sur une droite (D1) passant par ladite surface plane et formant un deuxième angle (β2) avec un deuxième plan (P2) perpendiculaire à ladite surface plane et perpendiculaire audit premier plan (P1),
* observer lesdits caractères avec des moyens d'observation (8) électroniques, lesdits moyens d'observation électroniques étant situés au dessous de ladite pluralité de substrats, lesdits moyens d'observation électroniques comprenant un axe optique (9) au moins parallèle audit deuxième plan (P2) et déterminant un troisième angle (β3) avec ladite perpendiculaire (4) à ladite surface (3) plane, ledit axe optique (9) formant avec ledit premier plan (P1) un angle inférieur ou égal à 25°,
* identifier lesdits caractères dudit premier substrat au moins avec un logiciel de reconnaissance à réseaux de neurones, et
* déplacer au moins ladite première source lumineuse et lesdits moyens d'observation en translation parallèlement à un axe d'alignement de ladite pluralité des substrats, pour les placer en position d'identification des caractères d'un deuxième substrat de ladite pluralité de substrats.

2. Procédé selon la Revendication 1, ***caractérisé en ce que*** ledit premier angle (β1) est compris entre 35° et 65°, et de préférence égal à 45°.

3. Procédé selon la Revendication 1 ou 2, ***caractérisé en ce que*** ledit deuxième angle (β2) est compris entre 35° et 65°, et de préférence égal à 45°.

4. Procédé selon l'une quelconque des Revendications 1 à 3, ***caractérisé en ce que*** ledit troisième angle (β3) est compris entre 40° et 60°, et de préférence égal à 48°.

5. Procédé selon l'une quelconque des Revendications 1 à 4, ***caractérisé en ce que*** l'on éclaire lesdits caractères (1) au moyen d'au moins une deuxième source lumineuse (S2) symétrique à ladite première source lumineuse (S1) par rapport audit deuxième plan (P2).

6. Procédé selon l'une quelconque des Revendications 1 à 5, ***caractérisé en ce que*** l'on éclaire lesdits caractères au moyen d'une pluralité de sources lumineuses (Sn) située dans une pluralité de plans (Pn) passant par ladite surface (3) plane et définissant une pluralité d'angles respectifs (βn) avec une perpendiculaire (4) à ladite surface plane.

7. Dispositif d'identification de caractères (1), gravés sur des substrats (2), comprenant des moyens de positionnement desdits substrats, des moyens d'éclairage desdits caractères, des moyens d'observation desdits caractères, des moyens d'identification desdits caractères, ***caractérisé en ce que*** lesdits moyens de positionnement comprennent un panier (15) apte à maintenir lesdits substrats en position verticale et immobile, lesdits moyens de positionnement définissant au moins une surface (3) plane minimale apte à inscrire la totalité desdits caractères d'un substrat, en ce que lesdits moyens d'éclairage comprennent au moins une première source lumineuse (S1) située dans un premier plan (P1) passant par ladite surface (3) plane minimale et définissant un premier angle (β1) avec une perpendiculaire (4) à ladite surface plane, ladite première source lumineuse étant située sur une droite (D1) passant par ladite surface plane et formant un deuxième angle (β2) avec un deuxième plan (P2) perpendiculaire à ladite surface plane et perpendiculaire audit premier plan, en ce que lesdits moyens d'observation comprennent une caméra (8) électronique transmettant au moins une image auxdits moyens d'identification et comprenant un axe optique (9) au moins parallèle audit deuxième plan, déterminant un troisième angle (β3) avec ladite perpendiculaire (4) à ladite surface (3) plane, et formant avec ledit premier plan un angle inférieur ou égal à 25°, et en ce que ledit dispositif comprend des moyens de déplacement (11, 17) en translation desdits moyens d'éclairage et desdits moyens d'observation parallèlement à un axe d'alignement desdits substrats.

8. Dispositif selon la Revendication 7, ***caractérisé en ce que*** ledit premier angle (β1) est compris entre 35° et 65°, et de préférence égal à 45°.

9. Dispositif selon selon la Revendication 7 ou 8, ***caractérisé en ce que*** ledit deuxième angle (β2) est compris entre 35° et 65°, et de préférence égal à 45°.

10. Dispositif selon l'une quelconque des Revendications 7 à 9, ***caractérisé en ce que*** ledit troisième angle (β3) est compris entre 40° et 60°, et de préférence égal à 48°.

11. Dispositif selon l'une quelconque des Revendications 7 à 10, ***caractérisé en ce que*** lesdits moyens d'éclairage comprennent au moins une deuxième source lumineuse (S2) symétrique à ladite première source lumineuse (S1) par rapport audit deuxième plan (P2).

12. Dispositif selon l'une quelconque des Revendications 7 à 11, ***caractérisé en ce qu'***il comprend une pluralité de sources lumineuses (Sn) située dans une pluralité de plans (Pn) passant par ladite surface (3) plane et définissant une pluralité d'angles respectifs (βn) avec une perpendiculaire (4) à ladite surface plane.

13. Dispositif selon l'une quelconque des Revendications 7 à 12, ***caractérisé en ce que*** lesdits moyens de positionnement, lesdits moyens d'éclairage et lesdits moyens d'observation au moins s'étendent au dessous desdits substrats (2).

14. Dispositif selon l'une quelconque des Revendications 7 à 13, ***caractérisé en ce que*** lesdits moyens d'identification desdits caractères comprennent au moins un logiciel de reconnaissance à réseaux de neurones pour interpréter les images transmises par lesdits moyens d'observation.

## Patentansprüche

1. Verfahren zur Identifizierung von Zeichen, die auf einer Vielzahl von Substraten graviert sind, die vertikal und unbeweglich angeordnet sind,
dadurch gekennzeichnet, daß es mindestens die folgenden Schritte aufweist:
- Direktes Beleuchten der Zeichen (1) eines ersten Substrats (2) der Vielzahl von Substraten mittels mindestens einer ersten Lichtquelle (S1), die unter der Vielzahl von Substraten und in einer ersten Ebene (P1) liegt, die durch eine minimale ebene Fläche (3) verläuft, die die Gesamtheit der Zeichen des ersten Substrats erfaßt und welche erste Ebene (P1) einen ersten Winkel (β1) mit einer Senkrechten (4) zu der ebenen Fläche festlegt, wobei die erste Lichtquelle auf einer Geraden (D1) liegt, die durch die ebene Fläche verläuft und einen zweiten Winkel (β2) mit einer zweiten Ebene (P2) bildet, die senkrecht zu der ebenen Fläche und senkrecht zu der ersten Ebene (P1) ist,
- Beobachten der Zeichen mit elektronischen Beobachtungsmitteln (8), die unter der Vielzahl von Substraten liegen und eine optische Achse (9) aufweisen, die mindestens zu der zweiten Ebene (P2) parallel ist und einen dritten Winkel (β3) mit der zu der ebenen Fläche (3) verlaufenden Senkrechten (4) bestimmt, wobei die optische Achse (9) mit der ersten Ebene (P1) einen Winkel kleiner oder gleich 25° bildet;
- Identifizieren der Zeichen des ersten Substrats mindestens mit einer Erkennungssoftware mit Neuronennetzen und
- Verlagern von mindestens der ersten Lichtquelle und der Beobachtungsmittel durch Parallelverschiebung zu einer Achse, in der die Vielzahl der Substrate ausgerichtet sind, um sie in die Position zur Identifizierung der Zeichen eines zweiten Substrats der Vielzahl der Substrate zu bringen.

2. Verfahren nach Anspruch 1,
dadurch gekennzeichnet, daß der erste Winkel (β1) zwischen 35° und 65° und vorzugsweise gleich 45° beträgt.

3. Verfahren nach Anspruch 1 oder 2,
dadurch gekennzeichnet, daß der zweite Winkel (β2) zwischen 35° und 65° und vorzugsweise gleich 45° beträgt.

4. Verfahren nach einem der Ansprüche 1 bis 3,
dadurch gekennzeichnet, daß der dritte Winkel (β3) zwischen 40° und 60° und vorzugsweise gleich 48° beträgt.

5. Verfahren nach einem der Ansprüche 1 bis 4,
dadurch gekennzeichnet, daß die Zeichen (1) mittels mindestens einer zweiten Lichtquelle (S2) beleuchtet werden, die zu der ersten Lichtquelle (S1) symmetrisch ist bezogen auf die zweite Ebene (P2).

6. Verfahren nach einem der Ansprüche 1 bis 5,
dadurch gekennzeichnet, daß die Zeichen mittels einer Vielzahl von Lichtquellen (Sn) beleuchtet werden, die in einer Vielzahl von Ebenen (Pn) liegen, die durch die ebene Fläche (3) verlaufen und eine Vielzahl von entsprechenden Winkeln (βn) mit einer Senkrechten (4) zu der ebenen Fläche festlegen.

7. Vorrichtung zur Identifizierung von Zeichen (1), die auf Substrate (2) graviert sind, die Mittel zur Positionierung der Substrate, Mittel zur Beleuchtung der Zeichen, Mittel zur Beobachtung der Zeichen, Mittel zur Identifizierung der Zeichen aufweist,
dadurch gekennzeichnet, daß die Positionierungsmittel einen Korb (15) aufweisen, der geeignet ist, die Substrate in vertikaler Position und unbeweglich zu halten, wobei die Positionierungsmittel mindestens eine minimale ebene Fläche (3) festlegen, die geeignet ist, die Gesamtheit der Zeichen eines Substrats zu erfassen, daß die Beleuchtungsmittel mindestens eine erste Lichtquelle (S1) aufweisen, die in einer ersten Ebene (P1) liegt, die durch die minimale ebene Fläche (3) verläuft und einen ersten Winkel (β1) mit einer Senkrechten (4) zu der ebenen Fläche festlegt, wobei die erste Lichtquelle auf einer Geraden (D1) liegt, die durch die ebene Fläche verläuft und einen zweiten Winkel (β2) mit einer zweiten Ebene (P2) bildet, die senkrecht zu der ebenen Fläche und senkrecht zu der ersten Ebene verläuft, daß die Beobachtungsmittel eine elektronische Kamera (8) aufweisen, die mindestens ein Bild an die Identifizierungsmittel überträgt und eine optische Achse (9) aufweist, die mindestens parallel zu der zweiten Ebene ist, wobei die optische Achse (9) einen dritten Winkel (β3) mit der Senkrechten (4) zu der ebenen Fläche (3) bestimmt und mit der ersten Ebene einen Winkel kleiner oder gleich 25° bildet, und daß die Vorrichtung Mittel (11, 17) zur Verlagerung der Beleuchtungsmittel und Beobachtungsmittel durch Parallelverschiebung zu einer Achse aufweist, in der die Substrate ausgerichtet sind.

8. Vorrichtung nach Anspruch 7,
dadurch gekennzeichnet, daß der erste Winkel (β1) zwischen 35° und 65° und vorzugsweise gleich 45° beträgt.

9. Vorrichtung nach Anspruch 7 oder 8,
dadurch gekennzeichnet, daß der zweite Winkel (β2) zwischen 35° und 65° und vorzugsweise gleich 45° beträgt.

10. Vorrichtung nach einem der Ansprüche 7 bis 9,
dadurch gekennzeichnet, daß der dritte Winkel (β3) zwischen 40° und 60° und vorzugsweise gleich 48° beträgt.

11. Vorrichtung nach einem der Ansprüche 7 bis 10,
dadurch gekennzeichnet, daß die Beleuchtungsmittel mindestens eine zweite Lichtquelle (S2) aufweisen, die zu der ersten Lichtquelle (S1) symmetrisch ist bezogen auf die zweite Ebene (P2).

12. Vorrichtung nach einem der Ansprüche 7 bis 11,
dadurch gekennzeichnet, daß sie eine Vielzahl von Lichtquellen (Sn) aufweist, die in einer Vielzahl von Ebenen (Pn) liegen, die durch die ebene Fläche (3) verlaufen und eine Vielzahl von entsprechenden Winkeln (βn) mit einer Senkrechten (4) zu der ebenen Fläche festlegen.

13. Vorrichtung nach einem der Ansprüche 7 bis 12,
dadurch gekennzeichnet, daß die Positionierungsmittel, die Beleuchtungsmittel und die Beobachtungsmittel sich mindestens unter den Substraten (2) erstrecken.

14. Vorrichtung nach einem der Ansprüche 7 bis 13,
dadurch gekennzeichnet, daß die Mittel zur Identifizierung der Zeichen mindestens eine Erkennungssoftware mit Neuronennetzen aufweisen, um die durch die Beobachtungsmittel übertragenen Bilder zu interpretieren.

## Claims

1. Method of identifying characters engraved on a plurality of vertically and fixedly disposed substrates, characterised in that it comprises at least the following steps:
* illuminating, in a direct manner, the characters (1) of a first substrate (2) of said plurality of substrates by means of at least one first light source (S1), said first light source (S1) being situated below said plurality of substrates, said first light source (S1) being situated in a first plane (P1) passing through a minimal planar surface (3) which inscribes the totality of said characters of said first substrate and defining a first angle (β1) with a perpendicular (4) to said planar surface, said first light source being situated on a straight line (D1) passing through said planar surface and forming a second angle (β2) with a second plane (P2) perpendicular to said planar surface and perpendicular to said first plane (P1),
* observing said characters with electronic observation means (8), said electronic observation means being situated below said plurality of substrates, said electronic observation means comprising an optical axis (9) at least parallel to said second plane (P2) and detennining a third angle (β3) with said perpendicular (4) to said planar surface (3), said optical axis (9) forming an angle less than or equal to 25° with said first plane (P1),
* identifying said characters of said first substrate at least with one item of recognition software having networks of neurons, and
* displacing at least said first light source and said observation means by a movement parallel to an axis of alignment of said plurality of substrates, in order to place them in a position for identifying the characters of a second substrate of said plurality of substrates.

2. Method according to claim 1, characterised in that said first angle (β1) is between 35° and 65°, and preferably equal to 45°.

3. Method according to claim 1 or 2, characterised in that said second angle (β2) is between 35° and 65°, and preferably equal to 45°.

4. Method according to any of claims 1 to 3, characterised in that said third angle (β3) is between 40° and 60°, and preferably equal to 48°.

5. Method according to any of claims 1 to 4, characterised in that said characters (1) are illuminated by means of at least one second light source (S2) symmetrical to said first light source (S1) relative to said second plane (P2).

6. Method according to any of claims 1 to 5, characterised in that said characters are illuminated by means of a plurality of light sources (Sn) situated in a plurality of planes (Pn) passing through said planar surface (3) and defining a plurality of respective angles (βn) with a perpendicular (4) to said planar surface.

7. Device for identifying characters (1) engraved on substrates (2), comprising means for positioning said substrates, means for illuminating said characters, means for observing said characters, and means for identifying said characters, characterised in that said positioning means comprise a basket (15) suitable for maintaining said substrates in a vertical and fixed position, said positioning means defining at least one minimal planar surface (3) suitable for inscribing the totality of said characters of one substrate, in that said illuminating means comprise at least one first light source (S1) situated in a first plane (P1) passing through said minimal planar surface (3) and defining a first angle (β1) with a perpendicular (4) to said planar surface, said first light source being situated on a straight line (D1) passing through said planar surface and forming a second angle (β2) with a second plane (P2) perpendicular to said planar surface and perpendicular to said first plane, in that said observation means comprise an electronic camera (8) transmitting at least one image to said identifying means and comprising an optical axis (9) at least parallel to said second plane, detennining a third angle (β3) with said perpendicular (4) to said planar surface (3), and forming an angle less than or equal to 25° with said first plane, and in that said device comprises displacement means (11, 17) for moving said illuminating means and said observation means parallel to an axis of alignment of said substrates.

8. Device according to claim 7, characterised in that said first angle (β1) is between 35° and 65°, and preferably equal to 45°.

9. Device according to claim 7 or 8, characterised in that said second angle (β2) is between 35° and 65°, and preferably equal to 45°.

10. Device according to any of claims 7 to 9, characterised in that said third angle (β3) is between 40° and 60°, and preferably equal to 48°.

11. Device according to any of claims 7 to 10, characterised in that said illuminating means comprise at least one second light source (S2) symmetrical to said first light source (S1) relative to said second plane (P2).

12. Device according to any of claims 7 to 11, characterised in that it comprises a plurality of light sources (Sn) situated in a plurality of planes (Pn) passing through said planar surface (3) and defining a plurality of respective angles (βn) with a perpendicular (4) to said planar surface.

13. Device according to any of claims 7 to 12, characterised in that said positioning means, said illuminating means and said observation means at least extend below said substrates (2).

14. Device according to any of claims 7 to 13, characterised in that said means for identifying said characters comprise at least one item of recognition software having networks of neurons in order to interpret the images transmitted by said observation means.
